(19) **Europäisches Patentamt**
**European Patent Office**
**Office européen des brevets**

(11) **EP 3 182 446 B1**

(12) **EUROPEAN PATENT SPECIFICATION**

(45) Date of publication and mention
of the grant of the patent:
**05.06.2019 Bulletin 2019/23**

(51) Int Cl.:
*H01L 23/373* *(2006.01)*     *C08K 3/00* *(2018.01)*
*C08L 53/02* *(2006.01)*     *C08K 3/14* *(2006.01)*
*C08K 3/22* *(2006.01)*     *C08K 3/28* *(2006.01)*
*C08K 3/38* *(2006.01)*

(21) Application number: **15200653.2**

(22) Date of filing: **17.12.2015**

(54) **THERMAL INTERFACE MATERIAL**

THERMISCHES ZWISCHENMATERIAL

MATÉRIAU D'INTERFACE THERMIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**21.06.2017 Bulletin 2017/25**

(73) Proprietor: **3M Innovative Properties Company**
**St. Paul, MN 55133-3427 (US)**

(72) Inventors:
• **Eichler, Jens**
**41564 Kaarst (DE)**

• **Bieber, Pierre Reinhard**
**40221 Düssseldorf (DE)**
• **Schiller, Marion**
**41352 Korschenbroich (DE)**

(74) Representative: **Müller, Bruno**
**3M Deutschland GmbH**
**Carl-Schurz-Straße 1**
**41453 Neuss (DE)**

(56) References cited:
**EP-A1- 2 832 779**     **US-A1- 2003 226 997**
**US-A1- 2004 241 410**     **US-A1- 2011 204 280**

EP 3 182 446 B1

**Description**

FIELD

The present disclosure relates to thermal interface materials. Generally, the thermal interface materials are based on heat conducting fillers dispersed in a block copolymer resin system. Depending on the requirements, tackifiers and plasticizers may be included in the resin system. The resulting compositions have low volatile organic compound content.

SUMMARY

Briefly, in one aspect, the present disclosure provides a thermal interface material according to claim 1 comprising thermally conductive filler dispersed in a resin system. The resin system comprises a block copolymer and has a Volatile Organic Compound content of no greater than 500 ppm, e.g., no greater than 400 ppm, no greater than 200 ppm, and even no greater than 100 ppm.

In some embodiments, the block copolymer is selected from the group consisting of a styrene-isoprene-styrene block copolymer, an olefin block copolymer, and combinations thereof. In some embodiments, the styrene-isoprene-styrene block copolymer comprises a star block copolymer.

The resin system further comprises at least one tackifier, e.g., at least one tackifier having a Volatile Organic Compound content of no greater than 500 ppm. In some embodiments the resin system further comprises at least one plasticizer, e.g., at least one plasticizer having a Volatile Organic Compound content of no greater than 500 ppm.

In some embodiments, the thermal interface material comprises at least 60 percent by weight of the thermally conductive filler based on the total weight of the thermally conductive filler and the resin system. In some embodiments, the thermally conductive filler comprises hexagonal boron nitride. In some embodiments, the thermal interface material comprises at least 5 percent by weight of hexagonal boron nitride thermally conductive filler based on the total weight of the thermally conductive filler and the resin system.

The above summary of the present disclosure is not intended to describe each embodiment of the present invention. The details of one or more embodiments of the invention are also set forth in the description below. Other features, objects, and advantages of the invention will be apparent from the description and from the claims.

BRIEF DESCRIPTION OF THE DRAWINGS

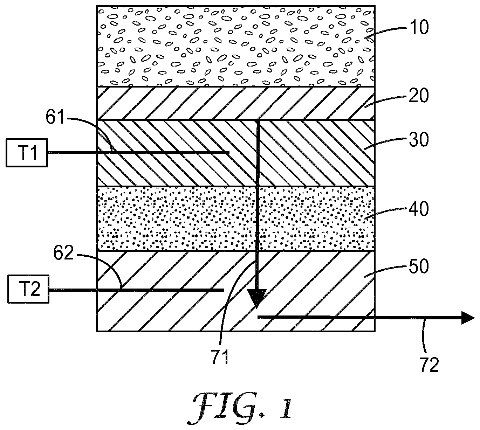

**FIG. 1** illustrates the test apparatus used to conduct the Thermal Conductivity Procedure.

DETAILED DESCRIPTION

Thermal interface materials are a key component for reliable performance of high performance batteries and other electronic devices. Generally, relatively large areas need to be covered by thermal interface materials within batteries. In some applications, such as battery applications for automotive, high thermal conductivity is required in combination with mechanical performance. For example, particular applications may require compressibility, ability to adjust to tolerance variations, and adequate mechanical performance. Additionally, some thermal transfer materials may be soft and conformable to provide maximum wet out for effective heat transfer and vibration damping, while still meeting other performance requirements.

There is a need for improved thermal interface materials. For example, conformability (allowing adjustment to tolerance mismatches of components in battery assembly) and shape stability (minimal deformation of the tape under its own weight) are conflicting requirements that need optimization. Additional needs include lower cost, improved handling, higher thermal conductivity, reduced levels of volatile organic compounds (VOCs), and low odor or smell.

A thermal interface material (TIM) of the present disclosure comprises thermally conductive fillers (also referred to as heat conducting fillers) dispersed in a resin system. As used herein, "resin system" refers to the block copolymer(s) and, if present, the tackifier(s) and plasticizer(s). Additional components may also be present, including those commonly found in TIMs, however, these items are referred to as "additives" distinct from the resin system.

Generally, the resin system comprises a block copolymer. Suitable block copolymers include at least one glassy block and at least one rubbery block. A glassy block exhibits a Tg of greater than room temperature, e.g., at least 20 °C, e.g., at least 25 °C. In some embodiments, the Tg of the glassy block is at least 40 °C, at least 60 °C, at least 80 °C, or even at least 100 °C. In some literature, glassy blocks have also been referred to as hard blocks. Generally, a rubbery block exhibits a glass transition temperature (Tg) of less than room temperature, e.g., less than 20 °C, e.g., less than 15 °C. In some embodiments, the Tg of the rubbery block is less than 0 °C, or even less than -10 °C. In some embodiments, the Tg of the rubbery block is less than -40 °C, or even less than -60 °C. In some literature, rubbery blocks have also been referred to as soft blocks.

In some embodiments, the resin system comprises at least one linear block copolymer, which can be described by the formula

$$R - (G)_m$$

wherein R represents a rubbery block, G represents a glassy block, and m, the number of glassy blocks, is 1 or 2. In some embodiments, m is one, and the linear block copolymer is a diblock copolymer comprising one rubbery block and one glassy block. In some embodiments, m is two, and the linear block copolymer comprises two glassy endblocks and one rubbery midblock, i.e., the linear block copolymer is a triblock copolymer.

In some embodiments, the rubbery block comprises a polymerized conjugated diene, a hydrogenated derivative of a polymerized conjugated diene, or combinations thereof. In some embodiments, the conjugated dienes comprise 4 to 12 carbon atoms. Exemplary conjugated dienes include butadiene, isoprene, ethylbutadiene, phenylbutadiene, piperylene, pentadiene, hexadiene, ethylhexadiene, and dimethylbutadiene. The polymerized conjugated dienes may be used individually or as copolymers with each other. In some embodiments, the conjugated diene is selected from the group consisting of isoprene, butadiene, ethylene butadiene copolymers, and combinations thereof.

In some embodiments, at least one glassy block comprises a polymerized monovinyl aromatic monomer. In some embodiments, both glassy blocks of a triblock copolymer comprise a polymerized monovinyl aromatic monomer. In some embodiments, the monovinyl aromatic monomers comprise 8 to 18 carbon atoms. Exemplary monovinyl aromatic monomers include styrene, vinylpyridine, vinyl toluene, alpha-methyl styrene, methyl styrene, dimethylstyrene, ethylstyrene, diethyl styrene, t-butylstyrene, di-n-butylstyrene, isopropylstyrene, other alkylated-styrenes, styrene analogs, and styrene homologs. In some embodiments, the monovinyl aromatic monomer is selected from the group consisting of styrene, styrene-compatible monomers or monomer blends, and combinations thereof.

As used herein, "styrene-compatible monomers or monomer blends" refers to a monomer or blend of monomers, which may be polymerized or copolymerized, that preferentially associate with polystyrene or with the polystyrene endblocks of a block copolymer. The compatibility can arise from actual copolymerization with monomeric styrene; solubility of the compatible monomer or blend, or polymerized monomer or blend in the polystyrene phase during hot melt or solvent processing; or association of the monomer or blend with the styrene-rich phase domain on standing after processing.

In some embodiments, the linear block copolymer is diblock copolymer. In some embodiments, the diblock copolymer is selected from the group consisting of styrene-isoprene, and styrene-butadiene. In some embodiments, the linear block copolymer is a triblock copolymer. In some embodiments the triblock copolymer is selected from the group consisting of styrene-isoprene-styrene, styrene-butadiene-styrene, styrene-ethylene-butadiene-styrene, and combinations thereof. Diblock and triblock copolymers are commercially available, e.g., those under the trade name VECTOR available from Dexco Polymer LP, Houston, Texas; and those available under the trade name KRATON available from Kraton Polymers U.S. LLC, Houston, Texas. As manufactured and/or purchased, triblock copolymers may contain some fraction of diblock copolymer as well.

In some embodiments, the resin system comprises at least one star block copolymer, sometimes referred to as a multi-arm block copolymer. A star block copolymer may be described by the formula

$$Y - (Q)_n$$

wherein Q represents an arm of the multi-arm block copolymer; n represents the number of arms and is a whole number of at least 3, i.e., the multi-arm block copolymer is a star block copolymer. Y is the residue of a multifunctional coupling agent. In some embodiments, n ranges from 3-10. In some embodiments, n ranges from 3-5. In some embodiments, n is 4. In some embodiments, n is equal to 6 or more.

Each arm, Q, independently has the formula G-R, wherein G is a glassy block; and R is a rubbery block. Exemplary rubbery blocks include polymerized conjugated dienes, such as those described above, hydrogenated derivatives of a polymerized conjugated diene, or combinations thereof. In some embodiments, the rubbery block of at least one arm comprises a polymerized conjugated diene selected from the group consisting of isoprene, butadiene, ethylene butadiene copolymers, and combinations thereof. In some embodiments, the rubbery block of each arm comprises a polymerized conjugated diene selected from the group consisting of isoprene, butadiene, ethylene butadiene copolymers, and combinations thereof.

Exemplary glassy blocks include polymerized monovinyl aromatic monomers, such as those described above. In some embodiments, the glassy block of at least one arm is selected from the group consisting of styrene, styrene-compatible blends, and combinations thereof. In some embodiments, the glassy block of each arm is selected from the group consisting of styrene, styrene-compatible blends, and combinations thereof.

Generally, the multifunctional coupling agent may be any material known to have functional groups that can react with carbanions of the living polymer to form linked polymers. For example, in some embodiments, the multifunctional coupling agent may be a polyalkenyl coupling agent. The polyalkenyl coupling agent may be aliphatic, aromatic, or heterocyclic. Exemplary aliphatic polyalkenyl coupling agents include polyvinyl and polyalkyl acetylenes, diacetylenes, phosphates, phosphites, and dimethacrylates (e.g., ethylene dimethacrylate). Exemplary aromatic polyalkenyl coupling agents include polyvinyl benzene, polyvinyl toluene, polyvinyl xylene, polyvinyl anthracene, polyvinyl naphthalene, and divinyldurene. Exemplary polyvinyl groups include divinyl, trivinyl, and tetravinyl groups. In some embodiments, divinylbenzene (DVB) may be used, and may include o- divinyl benzene, m-divinyl benzene, p-divinyl benzene, and mixtures thereof. Exemplary heterocyclic polyalkenyl coupling agents include divinyl pyridine, and divinyl thiophene. Other exemplary multifunctional coupling agents include silicon halides, polyepoxides, polyisocyanates, polyketones, polyanhydrides, and dicarboxylic acid esters.

In some embodiments, the resin system comprises an olefin block copolymer. Such olefin block copolymers contain at least one glassy block and at least one rubbery block. Exemplary olefin block copolymers include at least one crystalline olefin block (the glassy block) and at least one rubbery alpha-olefin (a-olefin) block. In some embodiments, the crystalline olefin blocks are selected from the group consisting of ethylene, propylene, and combinations thereof. In some embodiments, the $\alpha$-olefin blocks comprise $\alpha$-olefins having from 2 to 20, e.g., 2-10 carbon atoms. Exemplary $\alpha$-olefins include ethylene, propylene, 1-butene, 1- hexane, and 1-octene. Commercially available olefinic block copolymers include those available under the trade name INFUSE from Dow Chemical Company.

It is often desirable to have a conformable TIM. Such materials are able to conform to uneven surfaces, enhancing wet-out and the removal of air gaps that inhibit effective thermal conduction. However, it is also desirable to a have a dimensionally stable TIM such that excessive flow or distortion does not occur during use. Stress-strain curves are one way to describe the mechanical behavior of materials. The slope of the initial linear part is the Young's modulus, which describes the stiffness of a material. Generally low Young's modulus is preferred for good conformability. A yield point and maximum strength in the stress-strain curve will additionally help to maintain the dimensional stability of the TIM material.

In some embodiments it is desirable to have a TIM that exhibits viscoelastic behavior at room temperature (e.g., 20 °C). In some embodiments, the desired viscoelastic behavior may be achieved by selecting the appropriate block copolymer(s) and combining them with one or more tackifier(s), plasticizers(s), and combinations thereof.

In some embodiments, the resin systems of the present disclosure may include at least one tackifier. Tackifiers are materials that are compatible with at least one block of a block copolymer and which increase the Tg of that block. As used herein, a tackifier is "compatible" with a block if it is miscible with that block. A tackifier is "primarily compatible" with a block if it is at least miscible with that block, although it may also be miscible with other blocks. For example, a tackifier that is primarily compatible with a rubbery block will be miscible with the rubbery block, but may also be miscible with a glassy block. Similarly, a tackifier that is primarily compatible with a glassy block is miscible with the glassy block and may be miscible with a rubbery block.

The concept of miscibility is well known in the art, as are methods for evaluating miscibility. Generally, the miscibility of a tackifier with a block can be determined by measuring the effect of the tackifier on the Tg of that block. If a tackifier is miscible with a block it will increase the Tg of that block.

Generally, resins having relatively low solubility parameters tend to associate with the rubbery blocks; however, their solubility in the glassy blocks tends to increase as the molecular weights or softening points of these resins are lowered. Exemplary tackifiers that are primarily compatible with the rubbery blocks include polymeric terpenes, heterofunctional terpenes, coumarone-indene resins, rosin acids, esters of rosin acids, disproportionated rosin acid esters, hydrogenated, C5 aliphatic resins, C9 hydrogenated aromatic resins, C5/C9 aliphatic/aromatic resins, dicyclopentadiene resins, hydrogenated hydrocarbon resins arising from C5/C9 and dicyclopentadiene precursors, hydrogenated styrene monomer resins, and blends thereof.

Generally, resins having relatively high solubility parameters tend to associate with the glassy blocks; however, their solubility in the rubbery blocks tends to increase as the molecular weights or softening points of these resins are lowered. Exemplary tackifiers that are primarily compatible with the glassy blocks include coumarone-indene resins, rosin acids, esters of rosin acids, disproportionated rosin acid esters, C9 aromatics, alpha-methyl styrene, C9/C5 aromatic-modified aliphatic hydrocarbons, and blends thereof.

In some embodiments, the resin system includes at least one plasticizer. Plasticizers are materials that are compatible with at least one block of a block copolymer and which decrease the Tg of that block. Generally, a plasticizer that is compatible with a block will be miscible with that block and will lower the Tg of that block. Exemplary plasticizers include naphthenic oils, liquid polybutene resins, polyisobutylene resins, and liquid isoprene polymers.

Although a variety of block copolymers, tackifiers, and plasticizers are known, in the present disclosure they are selected to achieve a resin system with a low Volatile Organic Compound content (VOC content). As used herein, the Volatile Organic Compound contents of the raw materials are determined according to the TGA Test Method described in the Example section.

Generally, the VOC content of the entire TIM is most critical. The VOC content of the TIM is no greater than 400, no greater than 200, or even no greater than 100 ppm based on the total weight of the TIM.

It is generally desirable to select materials that themselves have a low VOC content. However, the VOC content of any particular component of the resin system is not critical provided the VOC content of the final TIM remains below the desired threshold. Therefore, in some embodiments, one or more components of the resin system may have a higher VOC content provided the VOC contents and relative amounts of such high VOC components are selected to achieve the desire low VOC content of the final product, i.e., the TIM.

In some embodiments, the VOC content of at least one component is no greater than 400, no greater than 300, or even no greater than 200 ppm based on the total weight of the component. In some embodiments, the VOC content of each block copolymer, tackifier, and plasticizer present in the resin system is no greater than 400, no greater than 300, or even no greater than 200 ppm based on the total weight of the component.

The relative amounts of block copolymers, tackifiers, and plasticizers will depend on the specific materials selected, their properties (such as Tg, modulus, and solubility parameter), and the desired properties of the TIM. In some embodiments, the resin system comprises at least 10 percent by weight (10 wt.%) block copolymer(s) based on the total weight of the resin system, e.g., at least 15 wt.%, or even at least 20 wt.%. In some embodiments, the resin system comprises no greater than 80 wt.% block copolymer(s) based on the total weight of the resin system, e.g., no greater than 60 wt.%, or even no greater than 40 wt.%.

In some embodiments, the resin system comprises at least 10 wt.% tackifier(s) based on the total weight of the resin system, e.g., at least 15 wt.%, or even at least 20 wt.%. In some embodiments, the resin system comprises no greater than 80 wt.% tackifier(s) based on the total weight of the resin system, e.g., no greater than 60 wt.%, or even no greater than 40 wt.%.

In some embodiments, the resin system comprises at least 10 wt.% plasticizer(s) based on the total weight of the resin system, e.g., at least 15 wt.%, at least 20 wt.%, or even at least 30 wt.%. In some embodiments, the resin system comprises no greater than 80 wt.% plasticizer(s) based on the total weight of the resin system, e.g., no greater than 60 wt.%, or even no greater than 50 wt.%.

Generally, the amounts of each of these components may be independently selected, provided the total weight percent of block copolymer(s), tackifier(s), and plasticizer(s) is 100%. The resin system comprises: (a) 20-40 wt.% block copolymers. (b) 20-40 wt.% tackifiers; and 30-50 wt.% plasticizer(s).

In addition to the resin system, the thermal interface materials of the present disclosure comprise at least one thermally conductive (i.e., heat conducting) filler. These fillers are dispersed in the resin system. Suitable thermally conductive fillers are known in the art. Exemplary thermally conductive fillers include, e.g., diamond, polycrystalline diamond, silicon carbide, alumina, aluminium trihydrate, aluminum nitride, aluminum, boron nitride (hexagonal or cubic), boron carbide, silica, graphite, amorphous carbon, zinc oxide, nickel, tungsten, silver, and combinations thereof. In some embodiments, the thermally conductive fillers are selected from the group consisting of aluminium trihydrate (ATH), boron nitride (BN), and combinations thereof. In some embodiments, the boron nitride is hexagonal boron nitride (HBN).

The thermally conductive filler may be in the form of particles, fibers, flakes, other conventional forms, or combinations thereof. Generally, the type of fillers and their amounts can be selected to achieve the desired thermal conductivity of the TIM. Generally, the thermally conductive filler may be present in the TIMs in an amount of at least 10 percent by weight, based on the total weight of the TIM. In other embodiments, thermally conductive filler may be present in amounts of at least 20, 30, 40, 50, 60, 70, 80, 90, 95, 96, 97, or 98 weight percent. In other embodiments, thermally conductive filler may be present in the TIMs in an amount of not more than 99, 95, 90, 85, 70 or 50 weight percent. For example, in some embodiments, the thermally conductive filler may be present in an amount from 30 to 95, e.g., 40 to 90, or even 50 to 80 wt.%.

In some embodiments, the thermally conductive fillers can be in the form of single crystal platelets or agglomerates formed from these single crystals. In some embodiments, the boron nitride comprises hexagonal boron nitride (h-BN). Single crystal boron nitride can vary in particle size from sub-micron up to D50 of 50 microns ($\mu$m) as measured by particle analyzer (Mastersizer). Although larger sizes can be used in some embodiments. Increasing particle size is generally preferred for increasing the thermal conductivity whereas smaller particle sizes generally have lower production costs. Since increasing particle sizes requires higher temperatures and processing times an upper limit for commercial use is currently around 15 $\mu$m. In some embodiments, agglomerates are used to attain even higher particle sizes.

Single crystal h-BN has a strong anisotropy in thermal conductivity with up to 400 W/mK in plane and as low as 4 W/mK through plane. By alignment of the plate-like particles in the melt flow, anisotropic thermal properties can be created in the resulting composite. Agglomerates help to reduce the anisotropy with the degree of anisotropy dependent on the particle alignment inside the agglomerate.

Additional components, referred to herein as "additives," may be included in the TIM. Suitable additional component include those known in the art. Exemplary additional components include fillers such as silica, talc, calcium carbonate and the like; pigments, dyes, or other colorants; glass or plastic beads or bubbles; core-shell particles, stabilizers (including, e.g., thermal and UV stabilizers), rheology modifiers, flame retardants, and foaming agents including thermal or chemical blowing agents and expandable microspheres. The selection of individual additives as well as combinations of additives, including their relative amounts depends on the desired end use requirements. Generally, such selections are within the knowledge of one of ordinary skill in the art.

Examples.

Table 1: Summary of materials used in the preparation of the examples.

| Name | Description | Trade Name and Source |
|---|---|---|
| BCP-1 | Styrene-Isoprene based star block copolymer (9% styrene) | KRATON D1340 Kraton Polymers |
| BCP-2 | Linear S-I-S block copolymer 15% styrene, includes 19% S-I diblock copolymer | KRATON D1161 Kraton Polymers |
| BCP-3 | Olefin block copolymer | INFUSE 9807 Dow Chemical Company |
| Tack-1 | Partially hydrogenated hydrocarbon resin tackifier | REGALITE R9100 Eastman Chemical Company |
| Tack-2 | Fully hydrogenated hydrocarbon resin tackifier | REGALITE R1090 (Eastman) |
| Tack-3 | Hydrocarbon resin tackifier | ESCOREZ 5615 Exxon Mobil Company |
| Tack-4 | Hydrocarbon resin tackifier | ESCOREZ 5340 (Exxon Mobil) |
| Tack-5 | Hydrocarbon resin tackifier | PLASTOLYN R1140 (Eastman) |
| Tack-6 | Beta-pinene based tackifier | PICCOLYTE S135 (Pinova) |
| Plast-1 | Mineral oil | NYPLAST 222B Nynas |
| Plast-2 | Polyisobutylene plasticizer Mw = 1.60 g/mol | GLISSOPAL 1000 BASF |
| Plast-3 | Polyisobutylene plasticizer Mw = 4.14 g/mol | GLISSOPAL V1500 (BASF) |
| Plast-4 | Polyisobutylene plasticizer Mw = 36.00 g/mol | OPPANOL B10N (BASF) |
| Plast-5 | Polyisobutylene plasticizer Mw = 51.00 g/mol | OPPANOL B12N (BASF) |
| TCF-A1 | Aluminiumtrihydrate (ATH) thermally conductive filler | APYRAL 24 Nabaltec |
| TCF-A2 | Aluminiumtrihydrate (ATH) thermally conductive filler | APYRAL 20X Nabaltec |
| TCF-B1 | Boron Nitride based thermally conductive filler (flake shape) | Boron Nitride Cooling Filler Flakes H30/500 (3M Company) |
| TCF-B2 | Boron Nitride based thermally conductive filler (platelet shape) | Boron Nitride Filler Platelets 006 3M Company |
| AO | Antioxidant | IRGANOX 1010 (BASF) |
| TIM-1 | Acrylic-based thermal interface material | TIM #5571-10 3M Company |
| TIM-1 | Acrylic-based thermal interface material | TIM #5590HP-12 3M Company |

Test methods.

TIM Preparation Procedure. The TIM formulations were hot melt processed in a Kneader (BRABENDER PLASTOGRAPH with a 370 ml kneading chamber). The SIS rubber (KRATON D1340), antioxidant (IRGANOX 1010), tackifier resin (ESCOREZ 5615) and plasticizer (OPPANOL B12N) were added carefully under constant kneading (60 rpm at 140 °C). The heat conductive fillers were added thereafter and the mixture was mixed until a homogeneous mass was obtained. Then the mass was dumped. In a heat press at 140 °C the TIM mass was placed between two silicone liners and pressed to a sheet of 2 mm thickness.

TGA Procedure. Thermogravimetric analysis (TGA) was conducted as follows. All TGA measurements were performed using a Q5000IR Thermogravimetric Analyzer from Texas Instruments. The samples were weighed in a platinum pan (20 to 30 milligrams) and placed with an auto sampler into the oven of the apparatus. The nitrogen flow through the oven was set at 25 mL/min and the nitrogen flow through the balance was set at 10 mL/min. The temperature was equilibrated at 30 °C and was then held for 15 minutes. Then the temperature was increased to 90 °C with a ramp of 60 °C/min. The temperature was held at 90 °C for 30 minutes.

The temperature was then further increased to 120 °C with a ramp of 60 °C/min and then held at 120 °C for 60 minutes. The weight losses after 30 minutes at 90 °C and after 60 minutes at 120°C were recorded and expressed in ppm by weight.

Thermal Desorption Procedure. Thermal desorption analysis of organic emissions was performed according to VDA test method 278 "Thermal Desorption Analysis of Organic Emissions for the Characterization of Non-Metallic Materials for Automobiles" (October 2011 Version). VDA method 278 is a test method used for the determination of organic emissions from non-metallic trim components used to manufacture the interior of motor vehicles. (VDA stands for "Verband der Automobilindustrie", the German Association of the Automotive Industry). VDA 278 is applied to non-metallic automotive materials and is a quantitative analysis of the emission of volatile organic compounds (VOC) and condensable substances (FOG).

VOC value - the sum of volatile and semi-volatile compounds up to n-C25 and

FOG value - the sum of the semi-volatile and heavy compounds from n-C14 to n-C32

For measuring the VOC and FOG values, adhesive samples of 30mg +/- 5mg were weighed directly into empty glass sample tubes. The volatile and semi-volatile organic compounds were extracted from the samples into the gas stream and were then re-focused onto a secondary trap prior to injection into a Gas Chromatograph for analysis. An automated thermal desorber - such as the Markes International Ultra-UNITY system - is preferably hereby used for the VDA 278 testing.

The test method comprises two extraction stages:

(1) VOC analysis, which involves desorbing the sample at 90°C for 30 minutes to extract VOC's up to n-C25 . This is followed by a semi-quantitative analysis of each compound as micrograms toluene equivalents per gram of sample.

(2) FOG analysis, which involves desorbing the sample at 120°C for 60 minutes to extract semi-volatile compounds ranging from n-C14 to n-C32. This is followed by semi-quantitative analysis of each compound as micrograms hexadecane equivalents per gram of sample.

The VOC value is determined by two measurements. The higher value of the measurements is indicated as the result, as described in the VDA278 test method

To determine the FOG value, the second sample is retained in the desorption tube after the VOC analysis and reheated to 120 °C for 60 minutes.

T/E Procedure. The mechanical behavior of the TIM constructions was analyzed in a tensile elongation (T/E) test according to ASTM D3759. Sample strips of 8 cm length and 1 cm width and 2 mm thickness were cut out of the TIM sheets. The top and bottom 2.5 cm borders were reinforced with a crepe tape and fixed in the jaws of a tensile elongation test machine (ZWICK Z020) equipped with a 200 N load cell. The initial length of the sample (L0) was 3 cm. The transversal bar of the tensile machine was then moved at 300 mm/min until the specimen broke. The applied force and deformation were recorded and plotted in a stress/strain diagram.

Thermal Conductivity Procedure. Thermal conductivity ($\lambda$) is defined by the Fourier law as follows:

$$\lambda = (Q/A)/(\Delta T/L)$$

where Q is the heat flow through a cross-sectional area A under a temperature difference ΔT over a length L.

A block diagram of the set-up is illustrated in FIG. 1. Steady-state measurements of thermal conductivity were conducted by placing sample (40) between aluminum block (30) and cold plate (50). Cold plate (50) provides for uniform heat flow and removal of heat to water. Heater (20) was positioned on aluminum block (20). Cork insulator (10) was located on top of heater (20). These multiple layers were loaded with 1 kg (not shown) to ensure good contact between the layers. The resulting heat flow through sample (40) is indicated by arrows (71 and 72). Temperatures T1 and T2 were measured using thermocouples (61, 62).

A steady state measurement of thermal conductivity relies on precise measurement of the heat flow and the temperature gradient. The temperature gradient ΔT = T1-T2 was measured with the two thermocouples. The heater generated heat flow (Q) by an electric current through a resistor (40 mW). The sample layer thickness (L) was 2 mm, the sample dimension was 25.4 mm by 25.4 mm yielding an area (A) of 645.16 square millimeters. The Thermal conductivity (λ) is then expressed in W/m/K.

Potential raw materials were screened for suitability by measuring their VOC content according to the TGA Procedure. The results are summarized in Table 2.

Table 2: VOC content of raw materials.

| Name | Weight Loss (ppm) | |
|---|---|---|
| | 30 min at 90 °C | 60 min at 120 °C |
| BCP-1 | 380 | 304 |
| BCP-2 | 636 | 182 |
| BCP-3 | 384 | 384 |
| Tack-1 | 1195 | 9968 |
| Tack-2 | 2086 | 20,442 |
| Tack-3 | 150 | 599 |
| Tack-4 | 359 | 559 |
| Tack-5 | 354 | 548 |
| Tack-6 | 437 | 686 |
| Plast-1 | 1388 | 17,994 |
| Plast-2 | 8838 | 18,575 |
| Plast-3 | 2481 | 4221 |
| Plast-4 | 504 | 1514 |
| Plast-5 | 261 | 521 |

Concerning the elastomer raw materials both the styrene-isoprene star block copolymer (BCP-1) and olefin block copolymer (BCP-3) showed very low VOC contents at 90 and 120 °C with values below 400 ppm. The linear styrene-isoprene block copolymer (BCP-2) also had low VOC contents at 90 °C (less than 800 ppm) and at 120 °C (less than 200 ppm).

The tackifiers may have to be carefully chosen with regard to VOC contents. While tackifiers Tack-1, and -2 had high VOC contents (greater than 1000 ppm), tackifiers Tack-3 to -6 had low values (less than 400 ppm at 90 °C, and less than 600 ppm at 120 °C).

Similarly, it may be important to select the proper plasticizer. Both the naphthenic oil (Plast-1) and the lower molecular weight PIB (Plast-2 and -3) showed high VOC contents (greater than 1000 ppm). In contrast, the higher molecular weight PIB (Plast-4 and -5) had low VOC contents (less than 600 ppm at 90 °C) and were heat stable.

Examples were prepared using low VOC content materials. Using the outgassing values of the raw materials reported in Table 2, one can choose the appropriate candidates for making a low VOC TIM. However, specific selections from such lists still requires achieving the desired balance of physical properties. In the examples that follow, the TIM formulations were made from a low outgassing styrene-isoprene star block copolymer (BCP-1), tackified with a low outgassing hydrocarbon tackifier (Tack-3), and plasticized with the low outgassing polyisobutylene (Plast-5). However, as illustrated herein, the method for screening for other appropriate low VOC content raw materials is straightforward, and the following results are exemplary of the results that can be achieved and are not intended to limit the invention to the specific materials tested.

Samples E1 to E9 were prepared according to the formulations summarized in Table 3. Various combinations of thermally conductive fillers were included to produce thermal interface materials. An antioxidant heat stabilizer (HS) was added to avoid material degradation during hot melt processing and to provide long term stabilization of the formulation.

Table 3: TIM compositions in parts per 100 parts resin system.

| | Sample | E1 | E2 | E3 | E4 | E5 | E6 | E7 | E8 | E9 |
|---|---|---|---|---|---|---|---|---|---|---|
| Resin system | BCP-1 | 30 | 30 | 30 | 30 | 30 | 30 | 30 | 30 | 30 |
| | Tack-3 | 30 | 30 | 30 | 30 | 30 | 30 | 30 | 30 | 30 |
| | Plast-5 | 40 | 40 | 40 | 40 | 40 | 40 | 40 | 40 | 40 |
| Additive | AO | 1.35 | 1.35 | 1.35 | 1.35 | 1.35 | 1.35 | 1.35 | 1.35 | 1.35 |
| Thermally conductive fillers | TCF-A1 | -- | -- | -- | -- | -- | 150 | -- | -- | -- |
| | TCF-A2 | -- | 300 | 275 | 150 | 137.5 | -- | -- | -- | -- |
| | TCF-B1 | -- | -- | -- | -- | -- | -- | -- | 300 | 150 |
| | TCF-B2 | -- | -- | 25 | -- | 12.5 | -- | 150 | -- | -- |

Table 4 shows the heat conductive filler loading in weight % based on the total weight of the TIM compositions - excluding the heat stabilizer. Heat conduction measurements were performed according to Thermal Conductivity Procedure. The results are also reported in Table 4.

Table 4: Weight percent thermally conductive filler loading and thermal conductivity.

| | Sample | E1 | E2 | E3 | E4 | E5 | E6 | E7 | E8 | E9 |
|---|---|---|---|---|---|---|---|---|---|---|
| Filler loading in wt.% based on the total weight of the TIM* | TCF-A1 | -- | -- | -- | -- | - | 60% | -- | -- | - |
| | TCF-A2 | -- | 75% | 68.75% | 60% | 55% | -- | -- | -- | -- |
| | TCF-B1 | -- | -- | -- | -- | -- | -- | -- | 75% | 60% |
| | TCF-B2 | -- | -- | 6.25% | -- | 5% | -- | 60% | -- | -- |
| | Total | 0% | 75% | 75% | 60% | 60% | 60% | 60% | 75% | 60% |
| Thermal Conductivity | W/m/K | 0.17 | 1.34 | 1.94 | 0.73 | 0.90 | 0.83 | 3.06 | 5.94 | 2.11 |
| * excluding the AO. | | | | | | | | | | |

Generally, the substitution of some of the aluminiumtrihydrate (TCF-A1 and A2) with hexagonal boron nitride (TCF-B1 and B2) improved the thermal conductivity. (Compare Samples E2 to E3 and E4 to E5.) For comparison, the reported thermal conductivities of two commercially available are: TIM-1 (1.3 W/m/K) and TIM-2 (2.0 W/m/K). As shown in Table 4, the use of hexagonal boron nitride led to significantly higher thermal conductivities relative to both the commercial products and the samples prepared with similar loadings of the aluminiumtrihydrate.

(See Samples E7, E8, and E9.)

The stress-strain behavior of the samples were obtained according to the T/E Procedure. Two replicates were tested for each sample. For comparison, the T/E Procedure was also performed with two commercially available, acrylic-based TIMs.

Table 5: Mechanical properties of samples.

| | width | thickness | Young's Modulus 0.1%-2% | Young's Modulus 0.05%-0.25% | Fracture strength | Elongation to break | Maximum force | Strain at maximum force |
|---|---|---|---|---|---|---|---|---|
| Sample | mm | mm | N/cm$^2$ | N/cm$^2$ | N/cm$^2$ | % | N/cm$^2$ | % |
| E1-1 | 10 | 1.67 | 0.32 | -- | -- | -- | 41 | 1220 |
| E1-2 | 10 | 1.60 | 0.88 | -- | -- | -- | 36 | 1176 |
| E2-1 | 10 | 1.90 | 366 | 395 | 44 | 322 | 55 | 186 |
| E2-2 | 10 | 1.94 | 376 | 414 | 31 | 337 | 56 | 184 |
| E3-1 | 10 | 1.89 | 666 | 734 | 59 | 174 | 74 | 113 |
| E3-2 | 10 | 1.90 | 594 | 640 | 35 | 164 | 71 | 109 |
| E4-1 | 10 | 1.95 | 159 | 160 | 44 | 789 | 51 | 603 |
| E4-2 | 10 | 1.90 | 148 | 161 | 39 | 626 | 45 | 510 |
| E5-1 | 10 | 1.93 | 212 | 241 | 44 | 616 | 57 | 469 |
| E5-2 | 10 | 1.93 | 202 | 218 | 44 | 648 | 59 | 483 |
| E6-1 | 10 | 1.96 | 230 | 237 | 60 | 603 | 70 | 460 |
| E6-2 | 10 | 1.92 | 233 | 244 | 65 | 716 | 75 | 512 |
| E7-1 | 10 | 1.89 | 893 | 1099 | 57 | 275 | 117 | 118 |
| E7-2 | 10 | 1.93 | 827 | 902 | 59 | 265 | 118 | 111 |
| E8-1 | 10 | 2.28 | 2984 | 5774 | 117 | 61 | 189 | 22 |
| E8-2 | 10 | 2.26 | 2694 | 4456 | 93 | 93 | 185 | 24 |
| E9-1 | 10 | 1.92 | 700 | 824 | 56 | 256 | 84 | 130 |
| E9-2 | 10 | 1.90 | 683 | 824 | 42 | 282 | 85 | 130 |
| 5570-1 | 10 | 2.01 | 46 | 60 | 26 | 231 | 37 | 158 |
| 5570-2 | 10 | 2.00 | 45 | 63 | 28 | 242 | 37 | 149 |
| 5571-1 | 10 | 2.09 | 122 | 159 | 40 | 69 | 66 | 61 |
| 5571-2 | 10 | 2.10 | 123 | 166 | 34 | 56 | 62 | 47 |

The Thermal Desorption Analysis according to the VDA test method was used to determine the VOC and FOG levels of some of the TIM samples, along with the two commercial products. The results are summarized in Table 6.

Table 6: VOC and FOG values.

| Sample | VOC (ppm) | FOG (ppm) | Odor (qualitative) |
|---|---|---|---|
| TIM-1 | 1326 | 1231 | Strong acrylate smell |
| TIM-2 | 1466 | 722 | Strong acrylate smell |
| E1 | 166 | 91 | No odor |
| E2 | 76 | 118 | No odor |
| E4 | 77 | 163 | No odor |
| E7 | 60 | 145 | No odor |
| E8 | 34 | 79 | No odor |
| E9 | 96 | 93 | No odor |

**Claims**

1. A thermal interface material comprising thermally conductive filler dispersed in a resin system, wherein the resin system comprises a block copolymer, a tackifier and at least one plasticizer having a Volatile Organic Compound content of no greater than 500 ppm as measured according to the TGA Procedure of the description, wherein the Volatile Organic Compound content of the thermal interface material is no greater than 400 ppm as measured according to the Thermal Desorption Procedure of the description, based on the total weight of the thermal interface material; and further wherein the resin system comprises

    (a) 20 to 40 weight percent block copolymers,
    (b) 20 to 40 weight percent tackifiers, and
    (c) 30 to 50 weight percent plasticizer(s),

    provided that the total weight percent of block copolymer(s), tackifier(s) and plasticizer(s) is 100%.

2. The thermal interface material of claim 1, wherein the block copolymer is selected from the group consisting of a styrene-isoprene-styrene block copolymer, an olefin block copolymer, and combinations thereof.

3. The thermal interface material of claim 2, wherein the block copolymer comprises a styrene-isoprene-styrene block copolymer.

4. The thermal interface material of claim 3, wherein the styrene-isoprene-styrene block copolymer comprises a star block copolymer.

5. The thermal interface material according to any one of the preceding claims, wherein the thermally conductive filler comprises hexagonal boron nitride.

6. The thermal interface material according to any one of the preceding claims, comprising at least 60 percent by weight of the thermally conductive filler based on the total weight of the thermally conductive filler and the resin system.

7. The thermal interface material according to claim 6, comprising at least 5 percent by weight of hexagonal boron nitride thermally conductive filler based on the total weight of the thermally conductive filler and the resin system.

8. The thermal interface material according to any one of the preceding claims, wherein the thermal interface material has a Volatile Organic Compound content of no greater than 200 ppm as measured according to the Thermal Desorption Procedure of the description.

**Patentansprüche**

1. Wärmeleitmaterial, umfassend wärmeleitfähigen Füllstoff, der in einem Harzsystem dispergiert ist, wobei das Harzsystem ein Blockcopolymer, einen Klebrigmacher und mindestens einen Weichmacher mit einem Gehalt an flüchtigen organischen Verbindungen von nicht mehr als 500 ppm umfasst, wie gemäß dem TGA-Verfahren der Beschreibung gemessen, wobei der Gehalt an flüchtigen organischen Verbindungen der Wärmeleitmaterial nicht größer als 400 ppm ist, wie gemäß dem Verfahren der thermischen Desorption der Beschreibung gemessen, bezogen auf das Gesamtgewicht der Wärmeleitmaterial; und wobei das Harzsystem Folgendes umfasst

    (a) 20 bis 40 Gew.-% Blockcopolymere,
    (b) 20 bis 40 Gewichtsprozent Klebrigmacher und
    (c) 30 bis 50 Gewichtsprozent eines oder mehrerer Weichmacher,

    vorausgesetzt, dass der Gesamtgewichtsprozentsatz von Blockcopolymer(en), Klebrigmacher(n) und Weichmacher(n) 100 % beträgt.

2. Wärmeleitmaterial nach Anspruch 1, wobei das Blockcopolymer ausgewählt ist aus der Gruppe bestehend aus einem Styrol-Isopren-Styrol-Blockcopolymer, einem Olefin-Blockcopolymer und Kombinationen davon.

3. Wärmeleitmaterial nach Anspruch 2, wobei das Blockcopolymer ein Styrol-Isopren-Styrol-Blockcopolymer umfasst.

4.  Wärmeleitmaterial nach Anspruch 3, wobei das Styrol-Isopren-Styrol-Blockcopolymer ein Sternblockcopolymer umfasst.

5.  Wärmeleitmaterial nach einem der vorstehenden Ansprüche, wobei der wärmeleitfähige Füllstoff hexagonales Bornitrid umfasst.

6.  Wärmeleitmaterial nach einem der vorstehenden Ansprüche, das zu mindestens 60 Gewichtsprozent den wärmeleitfähigen Füllstoff umfasst, bezogen auf das Gesamtgewicht des wärmeleitfähigen Füllstoffs und des Harzsystems.

7.  Wärmeleitmaterial nach Anspruch 6, das zu mindestens 5 Gewichtsprozent, bezogen auf das Gesamtgewicht des wärmeleitfähigen Füllstoffs und des Harzsystems, den wärmeleitfähigen hexagonalen Bornitrid-Füllstoff umfasst.

8.  Wärmeleitmaterial nach einem der vorstehenden Ansprüche, wobei das Wärmeleitmaterial einen Gehalt an flüchtigen organischen Verbindungen von nicht mehr als 200 ppm aufweist, wie gemäß dem Verfahren der thermischen Desorption der Beschreibung gemessen.

**Revendications**

1.  Matériau d'interface thermique comprenant une charge thermiquement conductrice dispersée dans un système de résine, dans lequel le système de résine comprend un copolymère séquencé, un agent poisseux et au moins un plastifiant ayant une teneur en composés organiques volatils non supérieure à 500 ppm telle que mesurée selon la procédure TGA de la description, dans lequel la teneur en composés organiques volatils du matériau d'interface thermique n'est pas supérieure à 400 ppm telle que mesurée selon la procédure de désorption thermique de la description, sur la base du poids total du matériau d'interface thermique ; et en outre dans lequel le système de résine comprend

    (a) de 20 à 40 % en poids de copolymères séquencés,
    (b) de 20 à 40 % en poids d'agents poisseux, et
    (c) de 30 à 50 % en poids de plastifiant(s),

    à condition que le pourcentage en poids total du ou des copolymère(s) séquencé(s), agent(s) poisseux et plastifiant(s) soit de 100 %.

2.  Matériau d'interface thermique selon la revendication 1, dans lequel le copolymère séquencé est choisi dans le groupe constitué par un copolymère séquencé de styrène-isoprène-styrène, un copolymère séquencé d'oléfine, et des combinaisons de ceux-ci.

3.  Matériau d'interface thermique selon la revendication 2, dans lequel le copolymère séquencé comprend un copolymère séquencé de styrène-isoprène-styrène.

4.  Matériau d'interface thermique selon la revendication 3, dans lequel le copolymère séquencé de styrène-isoprène-styrène comprend un copolymère séquencé en étoile.

5.  Matériau d'interface thermique selon l'une quelconque des revendications précédentes, dans lequel la charge thermiquement conductrice comprend du nitrure de bore hexagonal.

6.  Matériau d'interface thermique selon l'une quelconque des revendications précédentes, comprenant au moins 60 % en poids de la charge thermiquement conductrice sur base du poids total de la charge thermiquement conductrice et du système de résine.

7.  Matériau d'interface thermique selon la revendication 6, comprenant au moins 5 % en poids de charge thermiquement conductrice de nitrure de bore hexagonal sur la base du poids total de la charge thermiquement conductrice et du système de résine.

8.  Matériau d'interface thermique selon l'une quelconque des revendications précédentes, dans lequel le matériau d'interface thermique a une teneur en composés organiques volatils non supérieure à 200 ppm telle que mesurée selon la procédure de désorption thermique de la description.

*FIG. 1*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- *Thermal Desorption Analysis of Organic Emissions for the Characterization of Non-Metallic Materials for Automobiles,* October 2011